# EUROPEAN PATENT APPLICATION

(11) **EP 4 426 082 A1**
(43) Date of publication of application: **04.09.2024**
(21) Application number: 24158579.3
(22) Date of filing: 20.02.2024
(51) Int. Cl.: H10B 41/27, H10B 41/35, H10B 43/27, H10B 43/35

(54) **SEMICONDUCTOR DEVICES AND DATA STORAGE SYSTEMS INCLUDING THE SAME**

(30) Priority: 02.03.2023 KR 20230027946
(71) Applicant: Samsung Electronics Co., Ltd., Suwon-si, Gyeonggi-do 16677 (KR)
(72) Inventor: KIM, Hyunjung, 16677 Suwon-si, Gyeonggi-do (KR); PARK, Sejun, 16677 Suwon-si, Gyeonggi-do (KR); LEE, Jaeduk, 16677 Suwon-si, Gyeonggi-do (KR); JUNG, Eiwhan, 16677 Suwon-si, Gyeonggi-do (KR)
(74) Representative: Kuhnen & Wacker Patent- und Rechtsanwaltsbüro PartG mbB

(57) **Abstract**

A semiconductor device includes a first semiconductor structure (PERI; S1) including a substrate (201), circuit devices (220) on the substrate (201), and circuit interconnection lines (280) on the circuit devices (220); and a second semiconductor structure (CELL; S2) on the first semiconductor structure (PERI; S1) and having a first region (R1) and a second region (R2), wherein the second semiconductor structure (CELL; S2) includes gate electrodes (130); first channel structures (CH) in the first region (R1); second channel structures (SCH) in the first region (R1); and contact plugs (170) in the second region (R2), the gate electrodes (130) include first gate electrodes (130U2, 130U1, 130M, 130D2, 130L1, 130L2) having a first thickness in the vertical direction (Z) in the first region (R1) and second gate electrodes (130U1_1, 130U1_2, 130U1_3) having a second thickness (T3) in the vertical direction (Z) greater than the first thickness in the first region (R1), and the second gate electrodes (130U1_1, 130U1_2, 130U1_3) are commonly connected to one of the contact plugs (170).

## Description

### BACKGROUND

### 1. Field

Embodiments relate to a semiconductor device and a data storage system including the same.

### 2. Description of the Related Art

A semiconductor device able to store high-capacity data in a data storage system using data storage has been considered. Accordingly, a method for increasing data storage capacity of a semiconductor device has been researched. For example, as a method for increasing data storage capacity of a semiconductor device, a semiconductor device including memory cells disposed three-dimensionally, instead of memory cells disposed two-dimensionally, has been considered.

### SUMMARY

The embodiments may be realized by providing a semiconductor device including a first semiconductor structure including a substrate, circuit devices on the substrate, and circuit interconnection lines on the circuit devices; and a second semiconductor structure on the first semiconductor structure and having a first region and a second region, wherein the second semiconductor structure includes a plate layer; gate electrodes including at least one lower select gate electrode, memory gate electrodes, and upper select gate electrodes stacked in order and spaced apart from each other in a vertical direction perpendicular to an upper surface of the plate layer on the plate layer; first channel structures penetrating through the at least one lower select gate electrode and the memory gate electrodes and extending in the vertical direction, in the first region; second channel structures penetrating through the upper select gate electrodes, extending in the vertical direction, and connected to the first channel structures, respectively, in the first region; and contact plugs penetrating through the gate electrodes, extending in the vertical direction, and electrically connecting the gate electrodes to a portion of the circuit interconnection lines, in the second region, wherein the gate electrodes include first gate electrodes having a first thickness in the vertical direction in the first region and second gate electrodes having a second thickness in the vertical direction greater than the first thickness in the first region, and wherein the second gate electrodes are commonly connected to one of the contact plugs.

The embodiments may be realized by providing a semiconductor device including a plate layer; gate electrodes stacked and spaced apart from each other in a vertical direction perpendicular to an upper surface of the plate layer on the plate layer; channel structures penetrating through at least a portion of the gate electrodes and extending in the vertical direction; and contact plugs penetrating through the gate electrodes, extending in the vertical direction, and electrically connected to the gate electrodes, wherein the gate electrodes include first gate electrodes having a first thickness in the vertical direction and a second gate electrode having a second thickness in the vertical direction that is greater than the first thickness, and wherein, among the gate electrodes, at least two gate electrodes including the second gate electrode are commonly connected to a first contact plug.

The embodiments may be realized by providing a data storage system including a semiconductor storage device including a first semiconductor structure including circuit devices, a second semiconductor structure on one surface of the first semiconductor structure and having first and second regions, and an input/output pad electrically connected to the circuit devices; and a controller electrically connected to the semiconductor storage device through the input/output pad and configured to control the semiconductor storage device, wherein the second semiconductor structure includes a plate layer; gate electrodes stacked and spaced apart from each other in a vertical direction perpendicular to an upper surface of the plate layer on the plate layer; channel structures penetrating through at least a portion of the gate electrodes and extending in the vertical direction, in the first region; and contact plugs penetrating through the gate electrodes, extending in the vertical direction, and electrically connected to the gate electrodes, in the second region, wherein the gate electrodes include first gate electrodes having a first thickness in the vertical direction in the first region and second gate electrodes having a second thickness in the vertical direction and that is greater than the first thickness in the first region, and wherein, among the gate electrodes, at least two gate electrodes including the second gate electrode are in contact with the first contact plug among the contact plugs at side surfaces of the at least two gate electrodes.

### BRIEF DESCRIPTION OF DRAWINGS

Features will be apparent to those of skill in the art by describing in detail exemplary embodiments with reference to the attached drawings in which:
FIG. 1 is a plan view illustrating a semiconductor device according to an example embodiment of the present disclosure;
FIGS. 2A and 2B are cross-sectional views illustrating a semiconductor device according to an example embodiment of the present disclosure;
FIGS. 3A to 4B are enlarged views illustrating enlarged portions of a semiconductor device according to an example embodiment of the present disclosure;
FIGS. 5 and 6 are cross-sectional views illustrating a semiconductor device according to an example embodiment of the present disclosure;
FIGS. 7A and 7B are a cross-sectional view illustrating a semiconductor device and an enlarged view illustrating a portion of a semiconductor device according to example embodiments of the present disclosure;
FIG. 8 is a cross-sectional view illustrating a semiconductor device according to an example embodiment of the present disclosure;
FIGS. 9A to 10E are cross-sectional views of stages in a method of manufacturing a semiconductor device according to an example embodiment of the present disclosure;
FIG. 11 is a view illustrating a data storage system including a semiconductor device according to an example embodiment of the present disclosure;
FIG. 12 is a perspective view illustrating a data storage system including a semiconductor device according to an example embodiment of the present disclosure; and
FIG. 13 is a cross-sectional view illustrating a semiconductor package according to an example embodiment of the present disclosure.

### DETAILED DESCRIPTION

Hereinafter, embodiments of the present disclosure will be described as follows with reference to the accompanying drawings.

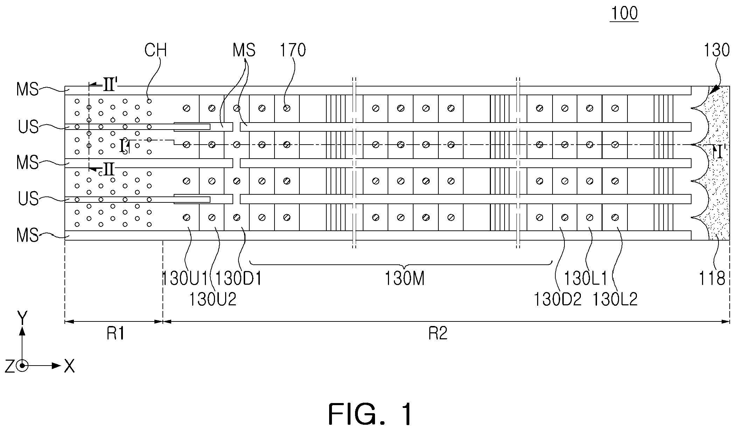

FIG. 1 is a plan view illustrating a semiconductor device according to an example embodiment.

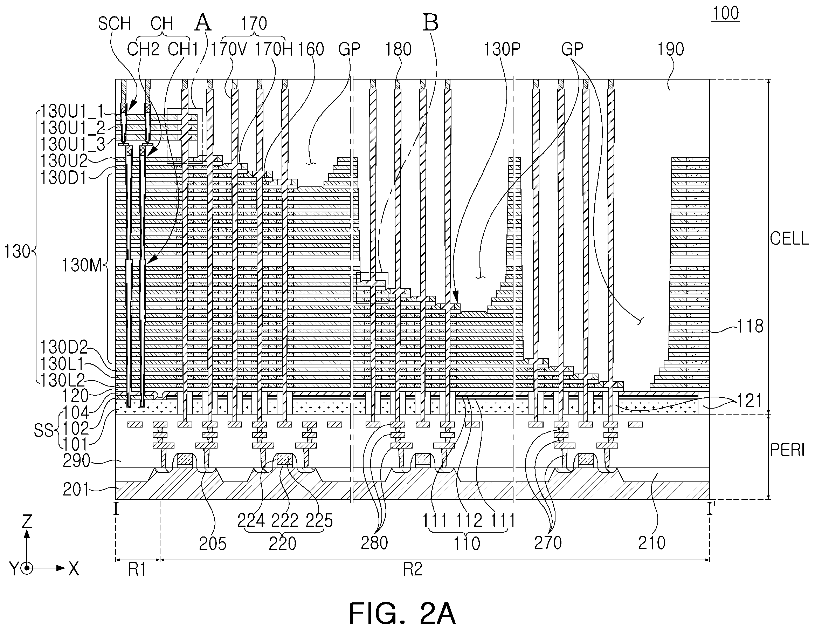

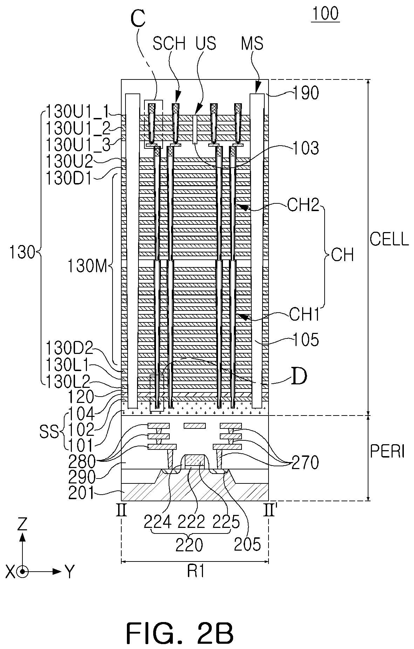

FIGS. 2A and 2B are cross-sectional views illustrating a semiconductor device according to an example embodiment, taken along lines I-I' and II-II' in FIG. 1.

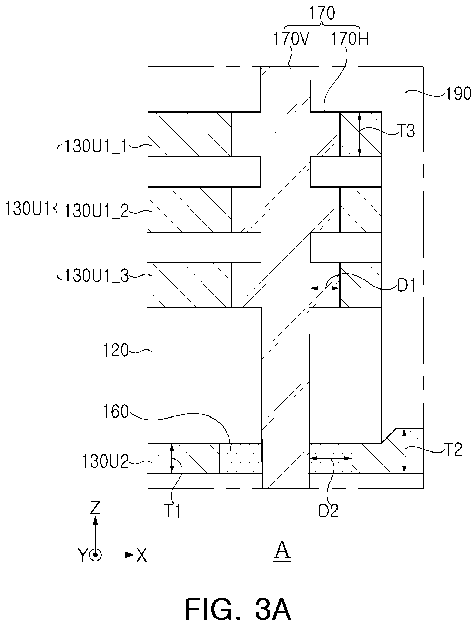

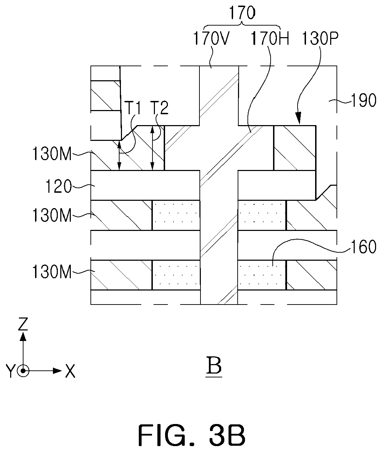

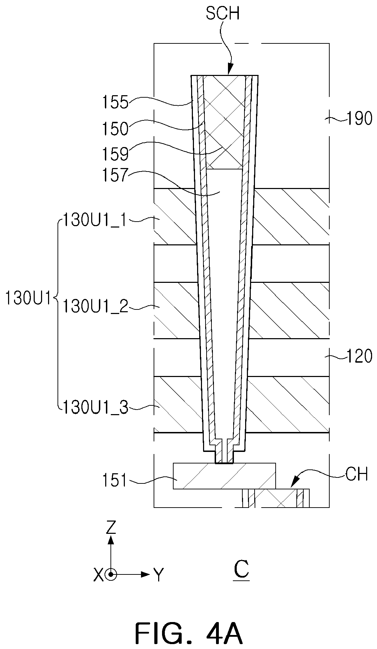

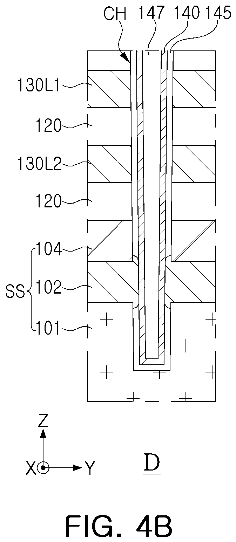

FIGS. 3A to 4B are enlarged views illustrating enlarged portions of a semiconductor device according to an example embodiment. FIG. 3A is an enlarged view illustrating region 'A' in FIG. 2A. FIG. 3B is an enlarged view illustrating region 'B' in FIG. 2A. FIG. 4A is an enlarged view illustrating region 'C' in FIG. 2B. FIG. 4B is an enlarged view illustrating region 'D' in FIG. 2B.

Referring to FIGS. 1 to 4B, a semiconductor device 100 may include a peripheral circuit region PERI, which is a first semiconductor structure including a substrate 201, and a memory cell region CELL, which is a second semiconductor structure including a plate layer 101. The memory cell region CELL may be on the peripheral circuit region PERI. In an implementation, the memory cell region CELL may be below the peripheral circuit region PERI. As used herein, the terms "first," "second," and the like are merely for identification and differentiation, and are not intended to imply or require sequential inclusion (e.g., a third element and a fourth element may be described without implying or requiring the presence of a first element or second element).

The peripheral circuit region PERI may include a substrate 201, impurities regions 205 and device isolation layers 210 in the substrate 201, circuit devices 220 on substrate 201, a peripheral region insulating layer 290, circuit contact plugs 270, and circuit interconnection lines 280.

The substrate 201 may have an upper surface extending in horizontal, e.g., X and Y, directions. An active region may be defined on the substrate 201 by the device isolation layers 210. The impurities regions 205 including impurities may be in a portion of the active region. The substrate 201 may include a semiconductor material, e.g., a group IV semiconductor, a group III-V compound semiconductor, or a group II-VI compound semiconductor. The substrate 201 may be a bulk wafer or an epitaxial layer. As used herein, the term "or" is not necessarily an exclusive term, e.g., "A or B" would include A, B, or A and B.

The circuit devices 220 may include planar transistors. Each of the circuit devices 220 may include a circuit gate dielectric layer 222, a spacer layer 224, and a circuit gate electrode 225. The impurities regions 205 may be source/drain regions in the substrate 201 at both sides of the circuit gate electrode 225.

The peripheral region insulating layer 290 may be on the circuit device 220 on the substrate 201. The peripheral region insulating layer 290 may include a plurality of insulating layers formed in different processes. The peripheral region insulating layer 290 may be formed of an insulating material.

The circuit contact plugs 270 and the circuit interconnection lines 280 may form a circuit interconnection structure electrically connected to the circuit devices 220 and the impurities regions 205. The circuit contact plugs 270 may have a cylindrical shape, and the circuit interconnection lines 280 may have a line form. An electrical signal may be applied to the circuit device 220 by the circuit contact plugs 270 and the circuit interconnection lines 280. In an implementation, the circuit contact plugs 270 may also be connected to the circuit gate electrode 225. The circuit interconnection lines 280 may be connected to the circuit contact plugs 270, may have a line form, and may be in a plurality of layers. The circuit contact plugs 270 and the circuit interconnection lines 280 may include a conductive material, e.g., tungsten (W), copper (Cu), or aluminum (Al), and each component may further include a diffusion barrier. In an implementation, the number of layers of the circuit contact plugs 270 and the number of layers of the circuit interconnection lines 280 may be varied.

The memory cell region CELL may have first and second regions R1 and R2, and may include a source structure SS, gate electrodes 130 stacked on the source structure SS, interlayer insulating layers 120 alternately stacked with the gate electrodes 130, first channel structures CH and second channel structures SCH penetrating through the stack structure of the gate electrodes 130 in or on the first region R1, first isolation regions MS extending by penetrating through the gate electrodes 130, second isolation regions US penetrating through a portion of the gate electrodes 130 at an upper portion, and contact plugs 170 connected to the gate electrodes 130 in the second region R2 and extending vertically (e.g., in the vertical Z direction). The memory cell region CELL may include a horizontal insulating layer 110 below the gate electrodes 130 in the second region R2, substrate insulating layers 121 penetrating the plate layer 101, studs 180 on the second channel structures SCH and the contact plugs 170, and a cell region insulating layer 190 covering the gate electrodes 130.

In the memory cell region CELL, on the first region R1, the gate electrodes 130 may be vertically stacked and the first channel structures CH may be disposed, and the memory cells may also be in the first region R1. In the second region R2, the gate electrodes 130 may extend to different lengths, and may be a region for electrically connecting the memory cells to the peripheral circuit region PERI. The second region R2 may be on at least one end of the first region R1 in at least one direction, e.g., the horizontal X-direction.

The source structure SS may include a plate layer 101, a first horizontal conductive layer 102, and a second horizontal conductive layer 104 stacked in order in the first region R1. In an implementation, the number of conductive layers included in the source structure SS may be varied.

The plate layer 101 may have a shape of a plate and may function as at least a portion of a common source line of the semiconductor device 100. The plate layer 101 may have an upper surface extending in a plane of the X and Y-directions. The plate layer 101 may include a conductive material. In an implementation, the plate layer 101 may include a semiconductor material, such as a group IV semiconductor, a group III-V compound semiconductor, or a group II-VI compound semiconductor. In an implementation, the group IV semiconductor may include silicon, germanium, or silicon-germanium. The plate layer 101 may further include impurities. The plate layer 101 may be a polycrystalline semiconductor layer (e.g., a polycrystalline silicon layer) or an epitaxial layer.

The first and second horizontal conductive layers 102 and 104 may be stacked in order on the upper surface of the plate layer 101 in the first region R1. The first horizontal conductive layer 102 may not extend to the second region R2, and the second horizontal conductive layer 104 may extend to the second region R2. The first horizontal conductive layer 102 may function as a portion of a common source line of the semiconductor device 100, and may function as a common source line together with the plate layer 101, for example. As illustrated in FIG. 4B, the first horizontal conductive layer 102 may be directly connected to the channel layer 140 around the channel layer 140. The second horizontal conductive layer 104 may be in contact with the plate layer 101 in a portion of regions of the second region R2 in which the first horizontal conductive layer 102 and the horizontal insulating layer 110 are not disposed.

The first and second horizontal conductive layers 102 and 104 may include a semiconductor material, such as polycrystalline silicon. In this case, at least the first horizontal conductive layer 102 may be doped with impurities of the same conductivity-type as that of the plate layer 101, and the second horizontal conductive layer 104 may be a doped layer or a layer including impurities diffused from the first horizontal conductive layer 102. In an implementation, the second horizontal conductive layer 104 may be replaced with an insulating layer.

The horizontal insulating layer 110 may be on the plate layer 101 on the same level as a level of the first horizontal conductive layer 102 in at least a portion of the second region R2. The horizontal insulating layer 110 may include first and second horizontal insulating layers 111 and 112 alternately stacked on the second region R2 of the plate layer 101. The horizontal insulating layer 110 may be layers remaining after a portion is replaced with the first horizontal conductive layer 102 in a process of manufacturing the semiconductor device 100.

The horizontal insulating layer 110 may include silicon oxide, silicon nitride, silicon carbide, or silicon oxynitride. The first horizontal insulating layers 111 and the second horizontal insulating layer 112 may include different insulating materials. In an implementation, the first horizontal insulating layers 111 may be formed of the same material as that of the interlayer insulating layers 120, and the second horizontal insulating layer 112 may be formed of a material different from that of the interlayer insulating layers 120.

The substrate insulating layers 121 may penetrate through the plate layer 101, the horizontal insulating layer 110, and the second horizontal conductive layer 104 in a portion of the second region R2. The substrate insulating layers 121 may be further disposed in the first region R1, and may be, e.g., in a region in which a through-via extending from the memory cell region CELL to the peripheral circuit region PERI is disposed. An upper surface of the substrate insulating layer 121 may be coplanar with an upper surface of the second horizontal conductive layer 104. The substrate insulating layer 121 may include an insulating material such as silicon oxide, silicon nitride, silicon carbide, or silicon oxynitride.

The gate electrodes 130 may be vertically stacked and spaced apart from each other on the plate layer 101 and may form a stack structure together with the interlayer insulating layers 120. The stack structure may include lower and upper stack structures configured to be vertically stacked. However, in example embodiments, the stack structure may be formed as a single stack structure.

The gate electrodes 130 may include first upper gate electrodes 130U1 (130U1_1, 130U1_2, and 130U1_3) forming string select transistors, second upper gate electrode 130U2 forming an erase transistor, first dummy gate electrode 130D1, memory gate electrodes 130M forming a plurality of memory cells, second dummy gate electrode 130D2, a first lower gate electrode 130L1 forming the erase transistor, and a second lower gate electrode 130L2 forming the ground select transistor. The number of memory gate electrodes 130M included in memory cells may be determined depending on capacity of the semiconductor device 100. The first upper gate electrodes 130U1 and the second lower gate electrode 130L2 may also be referred to as an upper select gate electrode and a lower select gate electrode, respectively. In an implementation, three first upper gate electrodes 130U1_1, 130U1_2, and 130U1_3 may be provided and may extend to the same length in the X-direction. In an implementation, the number of each of the second upper gate electrode 130U2, the first and second lower gate electrodes 130L1 and 130L2, and the first and second dummy gate electrodes 130D1 and 130D2 may be one to four or more, respectively, and may have a structure the same as or different from that of the memory gate electrodes 130M.

In an implementation, the positions of the first upper gate electrodes 130U1 and the second upper gate electrode 130U2 may be interchanged, or the positions of the first lower gate electrode 130L1 and the second lower gate electrode 130L2 may be interchanged. In an implementation, the second upper gate electrode 130U2 and/or the first lower gate electrode 130L1 may be omitted. In an implementation, a dummy gate electrode may be further included.

The gate electrodes 130 may be vertically stacked and spaced apart from each other on the first region R1, may extend to different lengths from the first region R1 to the second region R2 and may form step structures having a staircase form in the gate pad regions GP. In an implementation, as illustrated in FIG. 2A, the gate electrodes 130 may have a shape removed from an upper portion to a predetermined depth in the gate pad regions GP, and the gate pad regions GP may have different depths. The gate pad regions GP may have a shape of which a depth may increase as a distance from the first region R1 in the X-direction increases.

The gate electrodes 130 may form first and second step structures in an asymmetrical form in the X-direction in each gate pad region GP. The first step structure may have a staircase structure relatively adjacent to the first region R1 and a level of which may be lowered, e.g., go down, along or in the X-direction, and the second step structure may have a staircase structure relatively spaced apart from the first region R1 and a level of which may go up along or in the X-direction. In other words, the gate electrodes 130 may form a downward first step structure of which a level decreases in the vertical direction Z and an upward second step structure of which a level increases in the vertical direction Z. In an implementation, in each of the gate pad regions GP, a slope of the first step structure may be smaller than a slope of the second step structure in the first region R1. In an implementation, the first and second step structures may have symmetrical shapes. In the first step structure, the gate electrodes 130 may be connected to the contact plugs 170, and the gate electrodes 130 may form a dummy region or a dummy structure not connected to the contact plugs 170 in the second step structure.

In an implementation, as illustrated in FIG. 2A, levels of uppermost surfaces of the dummy structures of gate pad regions GP may be equal to each other. In an implementation, the levels of the uppermost surfaces of the dummy structures may decrease as a distance from the first region R1 increases in the X-direction. In an implementation, a specific shape of the step structure, and the number of the gate electrodes 130 included in each step structure may vary. The gate electrodes 130 may have a step structure in the Y-direction as well.

Due to the first step structure, the gate electrodes 130 in a lower portion may extend longer than the gate electrodes 130 in an upper portion and the gate electrodes 130 may have contact regions 130P exposed upwardly from the interlayer insulating layers 120, respectively. The gate electrodes 130 may be connected to the contact plugs 170, respectively, in the contact regions 130P, which may be end regions. The gate electrodes 130 other than the first upper gate electrodes 130U1 may have an increased thickness in the contact regions 130P.

The gate electrodes 130 may include first and second gate electrodes having different thicknesses. The first gate electrodes may be gate electrodes 130 excluding the first upper gate electrodes 130U1 among the gate electrodes 130. The second gate electrodes may be first upper gate electrodes 130U1 at an uppermost portion in the stack structure of the gate electrodes 130.

As illustrated in FIGS. 3A and 3B, the first gate electrodes may have a first thickness T1 in a region in which the other gate electrodes 130 are on the upper surface, including the first region R1. The first gate electrodes may have a third thickness T2, greater than the first thickness T1, as the thickness thereof may change, e.g., may be different, in the contact regions 130P. The second gate electrodes may have a constant thickness in the entire region including the first and second regions R1 and R2, and may have a second thickness T3 that is greater than the first thickness T1. The second thickness T3 may be greater than the first thickness T1 and may be substantially equal to the third thickness T2 or larger than the third thickness T2. In an implementation, the second thickness T3 may be about 1.05 times or more of the first thickness T1. In an implementation, the second thickness T3 may be, e.g., in a range of about 1.05 times to about 1.50 times of the first thickness T1.

The first upper gate electrodes 130U1, which are the second gate electrodes, may have the second thickness T3 and may extend to the same length (e.g., in the X direction). The second gate electrodes may be commonly connected to a single contact plug 170 through or at side surfaces, which will be described in greater detail in the description of the contact plugs 170 below.

The gate electrodes 130 may include a metal material, e.g., tungsten (W). In an implementation, the gate electrodes 130 may include polycrystalline silicon or a metal silicide material. The gate electrodes 130 may include the same material. In an implementation, the gate electrodes 130 may further include a diffusion barrier. In an implementation, the diffusion barrier may include tungsten nitride (WN), tantalum nitride (TaN), titanium nitride (TiN), or a combination thereof.

The interlayer insulating layers 120 may be between the gate electrodes 130. Similarly to the gate electrodes 130, the interlayer insulating layers 120 may be spaced apart from each other in the vertical Z direction perpendicular to the upper surface of the plate layer 101 and may extend (e.g., lengthwise) in the X-direction. The interlayer insulating layers 120 may include an insulating material such as silicon oxide or silicon nitride.

The sacrificial insulating layers 118 may be alternately stacked with the interlayer insulating layers 120 on an external side of the gate electrodes 130 and may form a mold structure. The sacrificial insulating layers 118 may be on the plate layer 101 and the substrate insulating layer 121. The sacrificial insulating layers 118 may be on the same level as a level of the gate electrodes 130, other than the first upper gate electrodes 130U1, with the same thickness, and may be disposed such that a side surface thereof may be in contact with the gate electrodes 130. The sacrificial insulating layers 118 and the interlayer insulating layers 120 may be alternately stacked and may form, e.g., a through-insulating region in which through-vias are disposed. The sacrificial insulating layers 118 may have a width the same as or a different from that of the lower substrate insulating layer 121. The sacrificial insulating layers 118 may be formed of an insulating material different from that of the interlayer insulating layers 120, and may include, e.g., silicon oxide, silicon nitride, or silicon oxynitride.

The first channel structures CH may penetrate through the gate electrodes 130 (other than the first upper gate electrodes 130U1), may extend in the Z-direction and may be connected to the plate layer 101. The first channel structures CH may form a memory cell string together with the second channel structures SCH, and may be spaced apart from each other while forming rows and columns on the plate layer 101 in the first region R1. The first channel structures CH may form a lattice pattern in the X-Y plane or may be in a zigzag pattern in one direction. The first channel structures CH may have a columnar shape and may have an inclined side surface of which a width may decrease toward the plate layer 101. At least a portion of the first channel structures CH including the first channel structures CH on the end of the first region R1 may be dummy channel structures.

The first channel structures CH may include lower and upper channel structures CH1 and CH2 vertically stacked. The first channel structures CH may have a form in which the lower channel structures CH1 and the upper channel structures CH2 are connected to each other, and may have a bent portion due to a difference in width in the connection region. In an implementation, the number of channel structures stacked in the Z-direction may be varied.

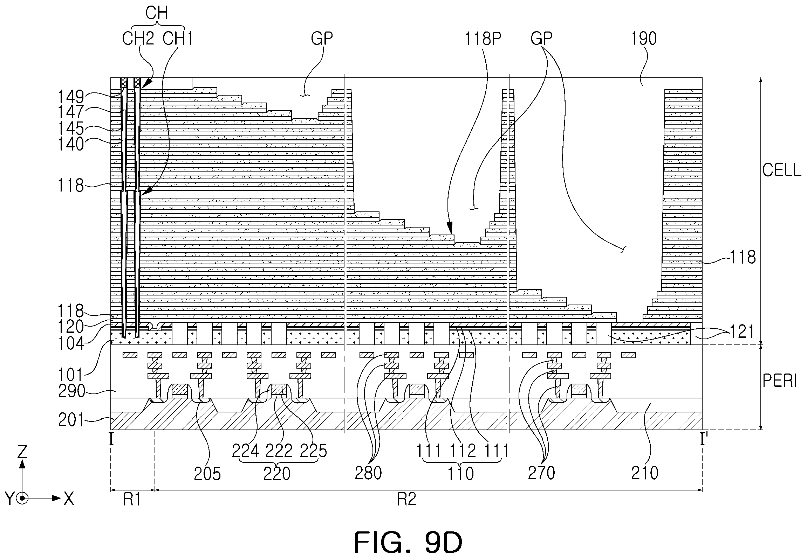

Each of the first channel structures CH may include a channel layer 140, a gate dielectric layer 145, a channel buried insulating layer 147, and a channel pad 149 (see FIG. 9D) in a lower channel hole. As illustrated in the enlarged view in FIG. 4B, the channel layer 140 may have an annular shape surrounding the internal channel buried insulating layer 147, and the channel layer 140 may have a columnal shape such as a cylindrical shape or a prism shape. The channel layer 140 may be connected to the first horizontal conductive layer 102 in a lower portion. The channel layer 140 may include a semiconductor material such as polycrystalline silicon or single crystal silicon.

The gate dielectric layer 145 may be between the gate electrodes 130 and the channel layer 140. In an implementation, the gate dielectric layer 145 may include a tunneling layer, a charge storage layer, and a blocking layer stacked in order from the channel layer 140. The tunneling layer may tunnel electric charges into the charge storage layer, and may include, e.g., silicon oxide (SiO₂), silicon nitride (Si₃N₄), silicon oxynitride (SiON), or a combination thereof. The charge storage layer may be a charge trap layer or a floating gate conductive layer. The blocking layer may include silicon oxide (SiO₂), silicon nitride (Si₃N₄), silicon oxynitride (SiON), a high-k dielectric material, or a combination thereof. In an implementation, at least a portion of the gate dielectric layer 145 may extend in a horizontal direction along the gate electrodes 130.

The channel pad 149 may be only on an upper end of the upper second channel structure CH2. The channel pad 149 may include, e.g., doped polycrystalline silicon.

The channel layer 140, the gate dielectric layer 145, and the channel buried insulating layer 147 may be connected to each other between the lower channel structure CH1 and the upper channel structure CH2. The interlayer insulating layer 120 having a relatively thick thickness may be between the lower channel structure CH1 and the upper channel structure CH2. In an implementation, the thickness of each of the interlayer insulating layers 120 may be varied.

The second channel structures SCH may penetrate through the first upper gate electrodes 130U1, may extend in the Z-direction, and may be connected to the first channel structures CH, respectively. The second channel structures SCH may be on the first channel structures CH, respectively, and may be horizontally or laterally shifted from the first channel structures CH.

Each of the second channel structures SCH may include an upper channel layer 150, an upper gate dielectric layer 155, an upper channel buried insulating layer 157, and an upper channel pad 159 in an upper channel hole, and may further include a connection pad 151 below the upper channel hole. As illustrated in the enlarged view in FIG. 4A, the upper channel layer 150 may have an annular shape surrounding the upper channel buried insulating layer 157 therein. The upper channel layer 150 may be connected to the connection pad 151 at a lower portion and may be electrically connected to the channel layer 140 of the first channel structure CH through the connection pad 151.

As for the materials of the upper channel layer 150, the upper gate dielectric layer 155, the upper channel buried insulating layer 157, and the upper channel pad 159, the descriptions of the channel layer 140, the gate dielectric layer 145, the channel buried insulating layer 147, and the channel pad 149 may be applied. The connection pad 151 may include a conductive material, e.g., polycrystalline silicon.

The first isolation regions MS may penetrate through at least a portion of the gate electrodes 130 and may extend in the X-direction. As illustrated in FIG. 1, the first isolation regions MS may be parallel to each other. The first isolation regions MS may penetrate through the gate electrodes 130 stacked on the plate layer 101, may further penetrate through the first and second horizontal conductive layers 102 and 104 therebelow and may be connected to the plate layer 101. In an implementation, the first isolation regions MS may penetrate through the gate electrodes 130 other than the first upper gate electrodes 130U1. A portion of the isolation regions MS may extend as an integrated region along the first region R1 and the second region R2, and the other portion may extend only to a portion of the second region R2 or may be intermittently in the first region R1 and the second region R2. In an implementation, the arrangement form of the first isolation regions MS and the number of the first isolation regions MS may vary.

A gate isolation insulating layer 105 may be in each of the first isolation regions MS. The gate isolation insulating layer 105 may have a shape of which a width may decrease toward the plate layer 101 due to a high aspect ratio. The gate isolation insulating layer 105 may include an insulating material, e.g., silicon oxide, silicon nitride, or silicon oxynitride.

Second isolation regions US may extend in the X-direction between the first isolation regions MS adjacent to each other, as illustrated in FIG. 1. The second isolation regions US may be in a portion of the second region R2 and the first region R1. The second isolation regions US may penetrate through the first upper gate electrodes 130U1 at an uppermost region of the gate electrodes 130. As illustrated in FIG. 2B, the second isolation regions US may divide or separate first upper gate electrodes 130U1_1, 130U1_2, and 130U1_3 in the Y-direction.

Each of the second isolation regions US may include an upper isolation insulating layer 103. The upper isolation insulating layer 103 may include an insulating material, e.g., silicon oxide, silicon nitride, or silicon oxynitride.

The contact plugs 170 may be connected to the contact regions 130P of the gate electrodes 130 in an uppermost portion in the second region R2. The contact plugs 170 may penetrate through at least a portion of the cell region insulating layer 190 and may be connected to the contact regions 130P of the gate electrodes 130 exposed upwardly, respectively. The contact plugs 170 may penetrate through the gate electrodes 130 below the contact regions 130P, may penetrate through the second horizontal conductive layer 104, the horizontal insulating layer 110, and the plate layer 101, and may be connected to the circuit interconnection lines 280 in the peripheral circuit region PERI. The contact plugs 170 may be spaced apart from the gate electrodes 130 below the contact regions 130P by the contact insulating layers 160. The contact plugs 170 may be spaced apart from the plate layer 101, the horizontal insulating layer 110, and the second horizontal conductive layer 104 by the substrate insulating layers 121.

As illustrated in FIGS. 3A and 3B, each of the contact plugs 170 may have a horizontally extended form in the contact region 130P. The contact plug 170 may include a vertical extension portion 170V extending in the Z-direction and a horizontal extension portion 170H extending horizontally from the vertical extension portion 170V and in contact with the gate electrode 130. The horizontal extension portion 170H may be along a circumference of the vertical extension portion 170V, and the entire side surface thereof may be surrounded by the gate electrode 130. The horizontal extension portion 170H may extend a first distance D1 from a side surface of the vertical extension portion 170V to an end of the horizontal extension portion 170H. The first distance D1 may be smaller than a second distance D2 (e.g., a distance from the side surface of the vertical extension portion 170V to external side surfaces of the contact insulating layers 160). The contact plugs 170 may be spaced apart from the gate electrodes 130 below the contact regions 130P, e.g., the gate electrodes 130 not electrically connected, by the contact insulating layers 160.

As illustrated in FIG. 3A, the contact plug 170 connected to the first upper gate electrodes 130U1_1, 130U1_2, and 130U1_3 may be physically and electrically connected to the three first upper gate electrodes 130U1_1, 130U1_2, and 130U1_3 in common. As described above, the first upper gate electrodes 130U1_1, 130U1_2, and 130U1_3 may have a relatively large second thickness T3, and the first upper gate electrodes 130U1_1, 130U1_2, and 130U1_3 may be connected to one contact plug 170 in common during the process of manufacturing the semiconductor device 100. Accordingly, the contact plug 170 connected to the first upper gate electrodes 130U1_1, 130U1_2, and 130U1_3 may include three horizontal extension portions 170H. The three horizontal extension portions 170H may extend to the same length or distance in the horizontal direction. In an implementation, first upper gate electrodes 130U1_1, 130U1_2, and 130U1_3 may form string select transistors, and may receive a common electrical signal in one of the memory cell strings. In an implementation, the first upper gate electrodes 130U1_1, 130U1_2, and 130U1_3 may form erase transistors.

The contact plugs 170 may include a conductive material, e.g., tungsten (W), copper (Cu), aluminum (Al), or an alloy thereof. In an implementation, the contact plugs 170 may include a barrier layer extending along a side surface and a bottom surface, or may have an air gap therein.

The contact insulating layers 160 may surround side surfaces of each of the contact plugs 170 below the contact regions 130P. The contact insulating layers 160 may be spaced apart from each other in the Z-direction around each of the contact plugs 170. The contact insulating layers 160 may be on substantially the same level as a level of the gate electrodes 130. The contact insulating layers 160 may include an insulating material, e.g., silicon oxide, silicon nitride, or silicon oxynitride.

The studs 180 may form a cell interconnection structure electrically connected to memory cells in the memory cell region CELL. The studs 180 may be connected to the second channel structures SCH and the contact plugs 170, and may be electrically connected to the first and second channel structures CH and SCH and the gate electrodes 130. In an implementation, the studs 180 may have a plug shape as illustrated, or may have a line form. In an implementation, the number of plugs and interconnection lines included in the cell interconnection structure may be varied. The studs 180 may include a metal, e.g., tungsten (W), copper (Cu), or aluminum (Al).

The cell region insulating layer 190 may cover the stack structure of the gate electrodes 130 and the contact plugs 170. The cell region insulating layer 190 may be formed of an insulating material or may include a plurality of insulating layers.

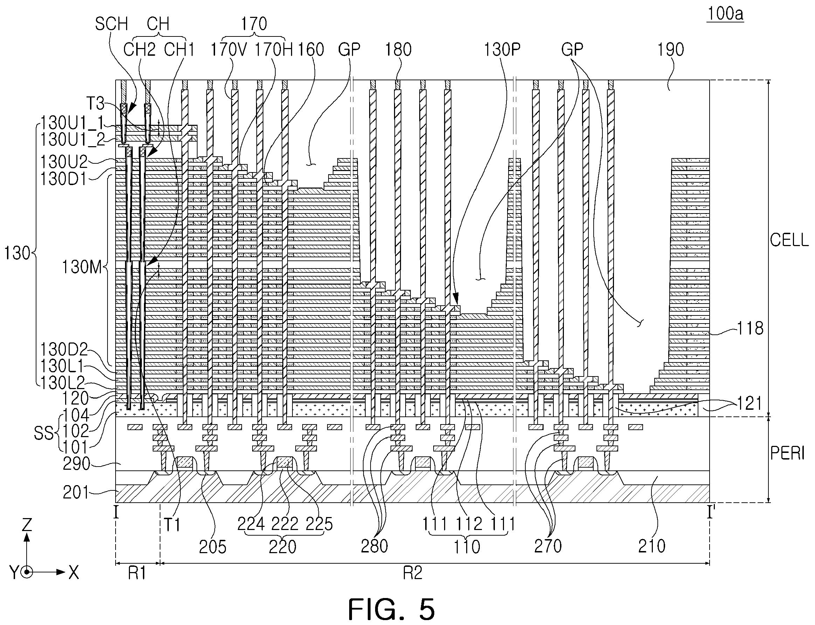

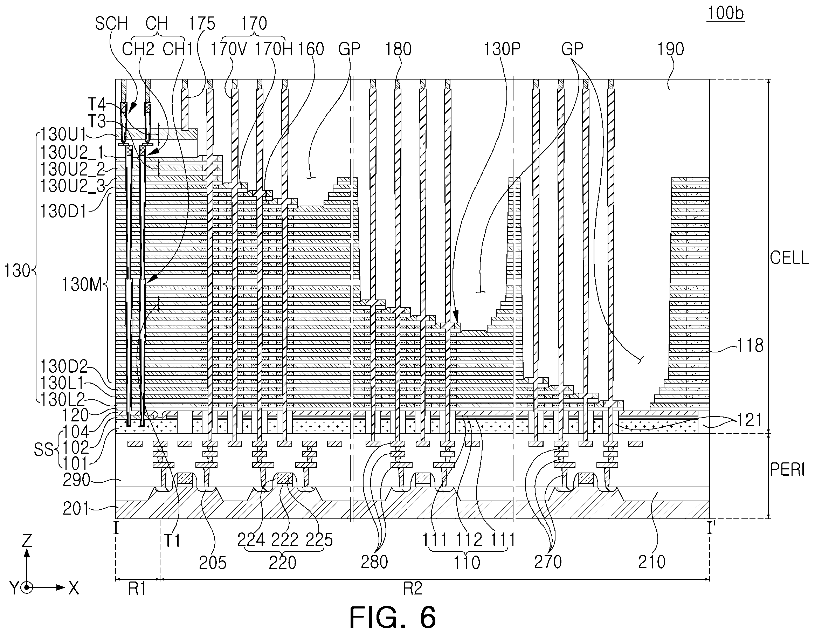

FIGS. 5 and 6 are cross-sectional views illustrating a semiconductor device according to an example embodiment, corresponding to FIG. 2A.

Referring to FIG. 5, in the semiconductor device 100a, first upper gate electrodes 130U1 (130U1_1 and 130U1_2) may include two gate electrodes and may extend to the same length in the X-direction. The first upper gate electrodes 130U1_1 and 130U1_2 may be commonly connected to a contact plug 170.

The first upper gate electrodes 130U1_1 and 130U1_2 may have a second thickness T3 throughout the first and second regions R1 and R2. The second thickness T3 may be greater than the first thickness T1 in the first region R1 of the other gate electrodes 130.

In an implementation, the lower first upper gate electrode 130U1_2 of the first upper gate electrodes 130U1 may have a second thickness T3 throughout the first and second regions R1 and R2, and the upper first upper gate electrode 130U1_1 may have a first thickness T1 in the first region R1 and a second thickness T3 only in the end region. In this case, the shape of the upper first upper gate electrode 130U1_1 may be similar to that of the memory gate electrodes 130M.

In an implementation, the number of first upper gate electrodes 130U1 commonly connected to one contact plug 170 may be varied. In an implementation, in addition to the first upper gate electrodes 130U1, a second upper gate electrode 130U2 or a first dummy gate electrode 130D1 may be further connected to the one contact plug 170.

Referring to FIG. 6, in the semiconductor device 100b, the gate electrodes 130 may include a first upper gate electrode 130U1 and three second upper gate electrodes 130U2 (130U2_1, 130U2_2, and 130U2_3), and the second channel structures SCH may penetrate through the first upper gate electrode 130U1. The semiconductor device 100b may further include an upper contact plug 175 connected to the first upper gate electrode 130U1.

Three second upper gate electrodes 130U2_1, 130U2_2, and 130U2_3 may be provided and may extend to the same length in the X-direction. The second upper gate electrodes 130U2_1, 130U2_2, and 130U2_3 may be commonly connected to the contact plug 170 and may receive the same electrical signal simultaneously. In an implementation, the number of gate electrodes included in the second upper gate electrodes 130U2 may be varied.

Among the second upper gate electrodes 130U2_1, 130U2_2, 130U2_3, the two second upper gate electrodes 130U2_2 and 130U2_3 in a lower portion may have a second thickness T3 throughout the first and second regions R1 and R2. The second thickness T3 may be greater than the first thickness T1 of the other gate electrodes 130 in the first region R1. The uppermost second upper gate electrode 130U2_1 may have a first thickness T1 in the first region R1 and a second thickness T3 only in the end region. In an implementation, the upper second upper gate electrode 130U2_1 may also have a second thickness T3 in the entire region.

The first upper gate electrode 130U1 may have a fourth thickness T4, and the fourth thickness T4 may be equal to or larger than the first thickness T1. In an implementation, the fourth thickness T4 may be greater than the second thickness T3.

The upper contact plug 175 may be connected to the first upper gate electrode 130U1 and may be above the lower surface of the first upper gate electrode 130U1 so as not to penetrate through the gate electrodes 130 below the first upper gate electrode 130U1. The upper contact plug 175 may be partially recessed into the first upper gate electrode 130U1 from the upper surface. In an implementation, a lower end of the upper contact plug 175 may penetrate through the first upper gate electrode 130U1 and may be in the interlayer insulating layer 120 below the first upper gate electrode 130U1.

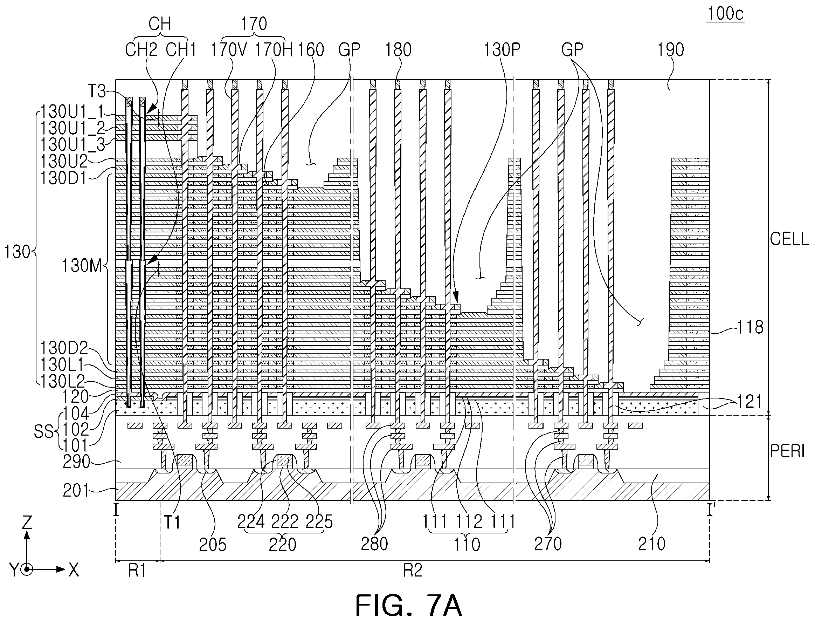

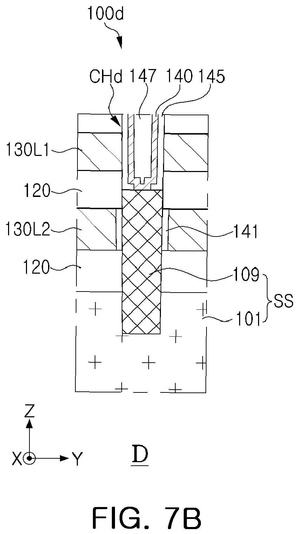

FIGS. 7A and 7B are a cross-sectional view illustrating a semiconductor device and an enlarged view illustrating a portion of a semiconductor device according to example embodiments. FIG. 7A is a cross-sectional view corresponding to FIG. 2A. FIG. 7B illustrates a region corresponding to FIG. 4B.

Referring to FIG. 7A, a semiconductor device 100c may not include the second channel structures SCH (see FIG. 2A) and may only include the first channel structures CH. The first channel structures CH may penetrate through the entire gate electrodes 130 including the first upper gate electrode 130U1. The first channel structures CH may include lower channel structures CH1 and upper channel structures CH2 which are vertically stacked. In an embodiment, the upper channel structures CH2 may be second channel structures CH2 and the lower channel structures CH1 may be first channel structures CH1.

As for the thickness of the gate electrodes 130 including the first upper gate electrodes 130U1, the description described above with reference to FIGS. 1 to 4B may be applied. In an implementation, the uppermost first upper gate electrode 130U1_1 among the first upper gate electrodes 130U1 may have a first thickness T1 in the first region R1 and may have a second thickness T3 only in the end region, and a thickness thereof may be configured to increase.

Referring to FIG. 7B, the semiconductor device 100d may not include the first and second horizontal conductive layers 102 and 104 on the plate layer 101, differently from the example embodiment in FIG. 4B. Also, the channel structure CHd may further include an epitaxial layer 109.

The epitaxial layer 109 may be on the plate layer 101 on the lower end of the channel structure CHd, and may form a source structure SS together with the plate layer 101. The epitaxial layer 109 may be on a side surface of at least one gate electrode, e.g., the second lower gate electrode 130L2. The epitaxial layer 109 may be in a region in which the plate layer 101 is recessed. The level of the lower surface of the epitaxial layer 109 may be higher than a level of the upper surface of the second lower gate electrode 130L2 and lower than a level of the lower surface of the first lower gate electrode 130L1. The epitaxial layer 109 may be connected to the channel layer 140 through an upper surface. A gate insulating layer 141 may be further disposed between the epitaxial layer 109 and the lower gate electrode 130L adjacent thereto.

The channel structure CHd configured as above may also be applied to the other example embodiments.

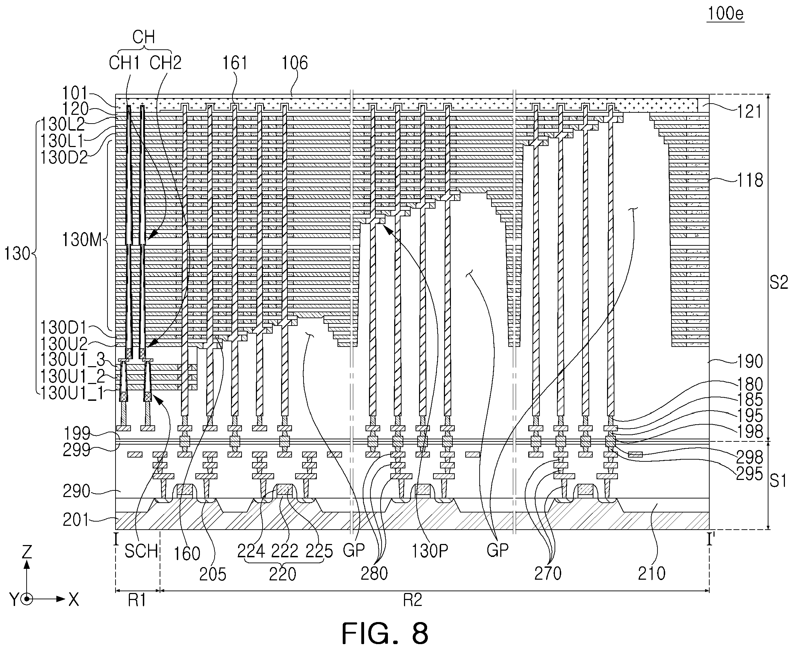

FIG. 8 is a cross-sectional view illustrating a semiconductor device according to an example embodiment.

Referring to FIG. 8, a semiconductor device 100e may include a first semiconductor structure S1 and a second semiconductor structure S2 bonded to each other by a wafer bonding method.

The description of the peripheral circuit region PERI described above with reference to FIGS. 1 to 2B may be applied to the first semiconductor structure S 1. In an implementation, the first semiconductor structure S1 may further include first bonding vias 295, first bonding metal layers 298, and first bonding insulating layer 299, which may be a bonding structure. The first bonding vias 295 may be above the uppermost circuit interconnection lines 280 and may be connected to the circuit interconnection lines 280. At least a portion of the first bonding metal layers 298 may be connected to the first bonding vias 295 on the first bonding vias 295. The first bonding metal layers 298 may be connected to the second bonding metal layers 198 of the second semiconductor structure S2. The bonding metal layers 298 together with the second bonding metal layers 198 may provide an electrical connection path according to bonding between the first semiconductor structure S1 and the second semiconductor structure S2. A portion of the first bonding metal layers 298 may not be connected to the lower circuit interconnection lines 280 and may be disposed only for bonding. The first bonding vias 295 and the first bonding metal layers 298 may include a conductive material such as copper (Cu). A first bonding insulating layer 299 may be around the first bonding metal layers 298. The first bonding insulating layer 299 may also function as a diffusion barrier of the first bonding metal layers 298, and may include, e.g., SiN, SiON, SiCN, SiOC, SiOCN, or SiO.

As for the second semiconductor structure S2, the description of the memory cell region CELL described above with reference to FIGS. 1 to 4B may be applied unless otherwise indicated. The second semiconductor structure S2 may further include cell interconnection lines 185, which is a cell interconnection structure, and may further include second bonding vias 195, second bonding metal layers 198, and second bonding insulating layer 199, which are bonding structures. The second semiconductor structure S2 may further include a passivation layer 106 covering the upper surface of the plate layer 101 and an upper insulating layer 161 disposed between the contact plugs 170 and the plate layer 101. The second semiconductor structure S2 may not include the first and second horizontal conductive layers 102 and 104 on a lower surface of the plate layer 101, differently from the example embodiment in FIG. 2A, and the channel layer 140 may directly contact the plate layer 101 at an upper end of the channel layer 140.

The cell interconnection lines 185 may be connected to the studs 180. In an implementation, the number of layers of plugs and interconnection lines included in the cell interconnection structure and the arrangement form thereof may be varied. The cell interconnection lines 185 may be formed of a conductive material, e.g., tungsten (W), aluminum (Al), or copper (Cu).

The second bonding vias 195 and the second bonding metal layers 198 may be below the lowermost cell interconnection lines 185. The second bonding vias 195 may connect the cell interconnection lines 185 to the second bonding metal layers 198, and the second bonding metal layers 198 may be bonded to the first bonding metal layers 298 of the first semiconductor structure S1. The second bonding insulating layer 199 may be bonded and connected to the first bonding insulating layer 299 of the first semiconductor structure S1. The second bonding vias 195 and the second bonding metal layers 198 may include a conductive material, e.g., copper (Cu). The second bonding insulating layer 199 may include, e.g., SiO, SiN, SiCN, SiOC, SiON, or SiOCN.

The first and second semiconductor structures S1 and S2 may be bonded to each other by bonding between the first bonding metal layers 298 and the second bonding metal layers 198 and the bonding between the first bonding insulating layer 299 and the second bonding insulating layer 199. The bonding between the first bonding metal layers 298 and the second bonding metal layers 198 may be, e.g., copper (Cu)-to-copper (Cu) bonding, and the first bonding insulating layer 299 and the second bonding insulating layer 199 may be, e.g., dielectric-to-dielectric bonding such as SiCN-to-SiCN bonding. The first and second semiconductor structures S1 and S2 may be bonded to each other by hybrid bonding including copper (Cu)-to-copper (Cu) bonding and dielectric-to-dielectric bonding.

The passivation layer 106 may be on the upper surface of the plate layer 101 and may protect the semiconductor device 100e. The upper insulating layer 161 may be between the contact plugs 170 and the plate layer 101. The upper insulating layer 161 may cover upper ends of the contact plugs 170 and may extend along the lower surface of the plate layer 101. In an implementation, the arrangement of the upper insulating layer 161 may be varied within a range of electrically isolating the contact plugs 170 from the plate layer 101. In an implementation, the upper insulating layer 161 may be disposed in the same manner as the substrate insulating layer 121 around the contact plugs 170 in FIG. 2B. The passivation layer 106 and the upper insulating layer 161 may include an insulating material, e.g., silicon oxide, silicon nitride, or silicon carbide, and may include a plurality of insulating layers according to example embodiments.

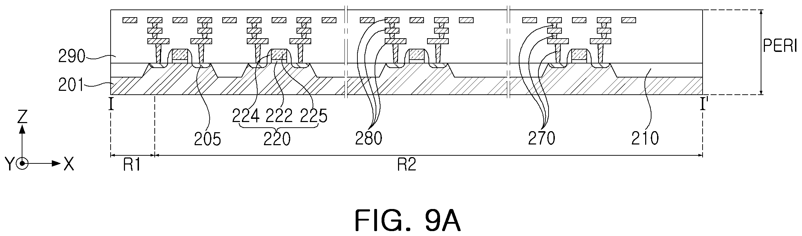

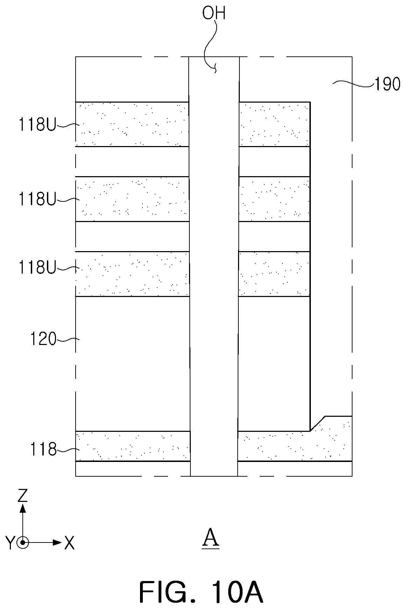

FIGS. 9A to 10E are cross-sectional views of stages in a method of manufacturing a semiconductor device according to an example embodiment. FIGS. 9A to 9I are cross-sectional views corresponding to FIG. 2A, and FIGS. 10A to 10E illustrate a region corresponding to FIG. 3A.

Referring to FIG. 9A, circuit devices 220 forming a peripheral circuit region PERI, a circuit interconnection structure, and a peripheral region insulating layer 290 may be formed on a substrate 201.

First, device isolation layers 210 may be formed in the substrate 201, and a circuit gate dielectric layer 222 and a circuit gate electrode 225 may be formed in order on the substrate 201. The device isolation layers 210 may be formed by, e.g., a shallow trench isolation (STI) process. The circuit gate dielectric layer 222 and the circuit gate electrode 225 may be formed using atomic layer deposition (ALD) or chemical vapor deposition (CVD). The circuit gate dielectric layer 222 may be formed of silicon oxide, and the circuit gate electrode 225 may be formed of polycrystalline silicon or a metal silicide layer. Thereafter, a spacer layer 224 and impurities regions 205 may be formed on both sidewalls of the circuit gate dielectric layer 222 and the circuit gate electrode 225. In an implementation, the spacer layer 224 may include a plurality of layers. The impurities regions 205 may be formed by performing an ion implantation process.

Among the circuit interconnection structures, the circuit contact plugs 270 may be formed by forming a portion of the peripheral region insulating layer 290, removing a portion by etching, and filling the portion with a conductive material. The circuit interconnection lines 280 may be formed, e.g., by depositing a conductive material and patterning the material.

The peripheral region insulating layer 290 may include a plurality of insulating layers. The peripheral region insulating layer 290 may become a portion in each of operations of forming the circuit interconnection structure. Accordingly, a peripheral circuit region PERI may be formed.

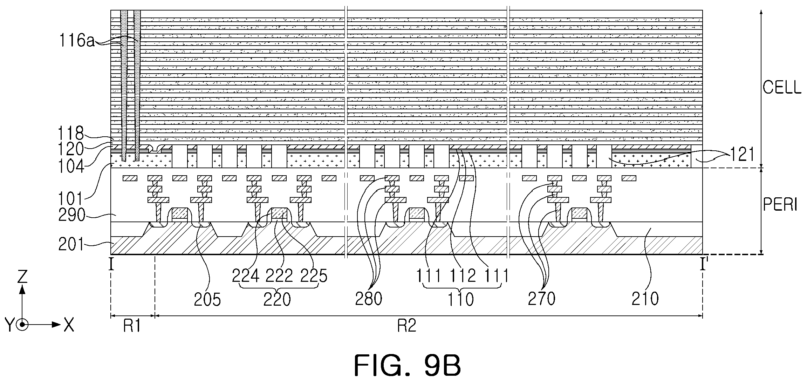

Referring to FIG. 9B, a plate layer 101 provided with a memory cell region CELL, a horizontal insulating layer 110, a second horizontal conductive layer 104, and a substrate insulating layer 121 may be formed on a peripheral circuit region PERI, a lower stack structure may be formed by alternately stacking the sacrificial insulating layers 118 and the interlayer insulating layers 120, and first channel sacrificial layers 116a may be formed.

The plate layer 101 may be formed on the peripheral region insulating layer 290. The plate layer 101 may be formed of, for example, polycrystalline silicon and may be formed by a CVD process. Polycrystalline silicon included in the plate layer 101 may include impurities.

The first and second horizontal insulating layers 111 and 112 included in the horizontal insulating layer 110 may be alternately stacked on the plate layer 101. The horizontal insulating layer 110 may be replaced with the first horizontal conductive layer 102 in FIG. 2B through a subsequent process. The first horizontal insulating layers 111 may include a material different from that of the second horizontal insulating layer 112. In an implementation, the first horizontal insulating layers 111 may be formed of the same material as that of the interlayer insulating layers 120, and the second horizontal insulating layer 112 may be formed of the same material as that of the subsequent sacrificial insulating layers 118. A portion of the horizontal insulating layer 110 may be removed by a patterning process in a portion of regions, e.g., the second region R2.

The second horizontal conductive layer 104 may be formed on the horizontal insulating layer 110 and may be in contact with the plate layer 101 in a region from which the horizontal insulating layer 110 is removed.

The substrate insulating layer 121 may be formed to penetrate through the plate layer 101 in a portion of regions including a region in which the contact plugs 170 (see FIG. 2A) are disposed. The substrate insulating layer 121 may be formed by removing a portion of the plate layer 101, the horizontal insulating layer 110, and the second horizontal conductive layer 104 and filling the insulating material therein. After the insulating material is filled, a planarization process may be further performed using a chemical mechanical polishing (CMP) process. Accordingly, the upper surface of the substrate insulating layer 121 may be substantially coplanar with the upper surface of the second horizontal conductive layer 104.

Thereafter, the lower stack structure may be formed on the second horizontal conductive layer 104 and the substrate insulating layer 121 on a level on which the lower channel structures CH1 (see FIG. 2A) of the first channel structures CH (see FIG. 2A) are disposed.

At least a portion of the sacrificial insulating layers 118 may be replaced with the gate electrodes 130 (see FIG. 2A) through a subsequent process. The sacrificial insulating layers 118 may be formed of a material different from that of the interlayer insulating layers 120, and may be formed of a material etched with etch selectivity under specific etching conditions for the interlayer insulating layers 120. In an implementation, the interlayer insulating layer 120 may be formed of silicon oxide or silicon nitride, and the sacrificial insulating layers 118 may be formed of a material different from the material of the interlayer insulating layer 120, e.g., silicon, silicon oxide, silicon carbide, or silicon nitride. In an implementation, the thicknesses of the interlayer insulating layers 120 may be the same. In an implementation, the thicknesses of the interlayer insulating layers 120 and the sacrificial insulating layers 118 the number of films included thereto may be varied.

The first channel sacrificial layers 116a may be formed in a position corresponding to the lower channel structures CH1 in the first region R1. The first channel sacrificial layers 116a may be formed by forming lower channel holes to penetrate through the lower stack structure, depositing a material included in the first channel sacrificial layers 116a on the lower channel holes, and performing a planarization process. The first channel sacrificial layers 116a may include, e.g., polycrystalline silicon.

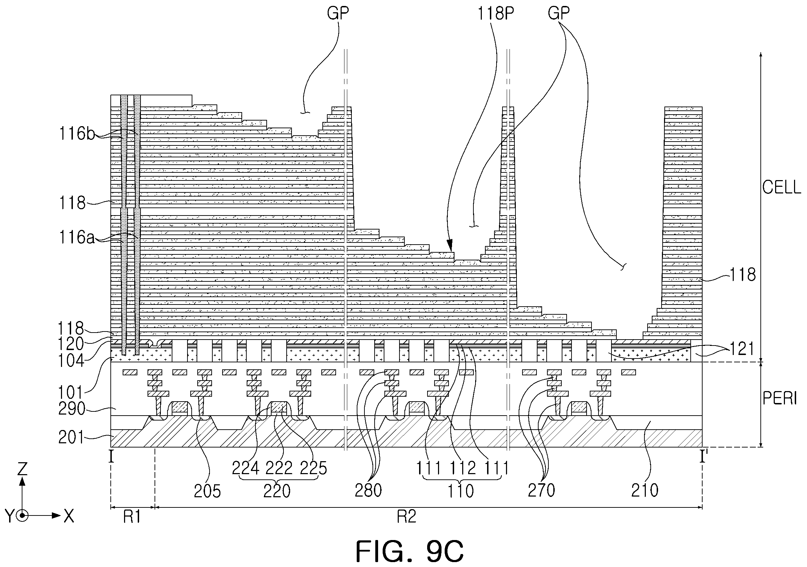

Referring to FIG. 9C, the sacrificial insulating layers 118 and the interlayer insulating layers 120 forming an upper stack structure may be alternately stacked on the lower stack structure, and gate pad regions GP and second channel sacrificial layers 116b may be formed.

In this process, the upper stack structure may be formed on the lower stack structure on a level on which the upper channel structures CH2 (see FIG. 2A) of the first channel structures CH (see FIG. 2A) are disposed.

The gate pad regions GP may be formed by repeatedly performing a photolithography process and an etching process for the sacrificial insulating layers 118 and the interlayer insulating layers 120. The gate pad regions GP may be formed in the second region R2, and may be formed to include a region in which the upper sacrificial insulating layers 118 extend shorter than the lower sacrificial insulating layers 118. In each gate pad region GP, step structures asymmetrical to each other may be formed such that upper surfaces and ends of the plurality of sacrificial insulating layers 118 may be exposed upwardly. In an implementation, the specific shape of the gate pad regions GP may be varied.

By further forming the sacrificial insulating layers 118 on the step structure of gate pad regions GP, the sacrificial insulating layers 118 in an uppermost portion in each region may have relatively thick preliminary contact regions 118P. The preliminary contact regions 118P may be formed on the step structure on the left side of which a slope may be gentle, e.g., the first step structure, and may not be formed in the step structure on the right side of which a slope may be relatively steep, e.g., the second step structure. In an implementation, the preliminary contact regions 118P may be formed in both the first and second step structures.

The second channel sacrificial layers 116b may be formed in a position corresponding to the upper channel structures CH2 in the first region R1. The second channel sacrificial layers 116b may be formed to be connected to the first channel sacrificial layers 116a, respectively. The second channel sacrificial layers 116b may be formed by depositing the same material as that of the first channel sacrificial layers 116a, e.g., polycrystalline silicon.

Referring to FIG. 9D, first channel structures CH penetrating through the lower stack structure and the upper stack structure may be formed.

First, a cell region insulating layer 190 covering the lower stack structure and the upper stack structure may be formed.

The first channel structures CH may be formed by forming hole-shaped channel holes by removing the first and second channel sacrificial layers 116a and 116b, and depositing at least a portion of a gate dielectric layer 145, which may include the channel layer 140, the channel buried insulating layer 147, and the channel pad 149 in order in the channel holes.

The gate dielectric layer 145 may be formed to have a uniform thickness using an ALD or CVD process. In this process, the entirety or a portion of the gate dielectric layer 145 may be formed, and a portion extending perpendicularly to the plate layer 101 along the first channel structures CH may be formed in this process. A channel layer 140 may be formed on the gate dielectric layer 145 in the channel holes. The channel buried insulating layer 147 may be formed to fill the channel holes and may be an insulating material. The channel pad 149 may be formed of a conductive material, e.g., polycrystalline silicon.

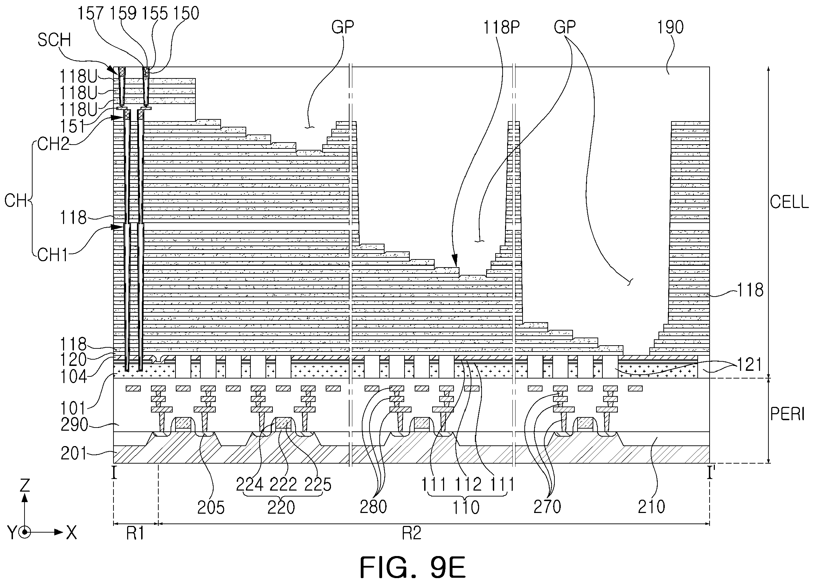

Referring to FIG. 9E, connection pads 151 may be formed, upper sacrificial insulating layers 118U and interlayer insulating layers 120 may be alternately stacked, and second channel structures SCH penetrating through the upper sacrificial insulating layers 118U and connected to first channel structures CH may be formed.

First, the connection pads 151 may be formed by being patterned on the first channel structures CH to be connected to the channel pads 149 of the first channel structures CH.

The upper sacrificial insulating layers 118U may be replaced with first upper gate electrodes 130U1_1, 130U1_2, and 130U1_3 (see FIG. 2A) through a subsequent process. The upper sacrificial insulating layers 118U may be formed to have a thickness greater than that of the sacrificial insulating layers 118 and may be patterned to extend shorter than the sacrificial insulating layers 118 therebelow.

Thereafter, a cell region insulating layer 190 covering the upper sacrificial insulating layers 118U may be further formed. To form the second channel structures SCH, upper channel holes in the form of holes penetrating through the upper sacrificial insulating layers 118U may be formed, and an upper gate dielectric layer 155, an upper channel layer 150, an upper channel buried insulating layer 157, and an upper channel pad 159 may be formed in order in the upper channel holes. Each layer may be formed in the same manner as in first channel structures CH. The upper channel layer 150 may be connected to the connection pad 151 on a lower end. Accordingly, second channel structures SCH including the connection pad 151, the upper gate dielectric layer 155, the upper channel layer 150, the upper channel buried insulating layer 157, and the upper channel pad 159 may be formed.

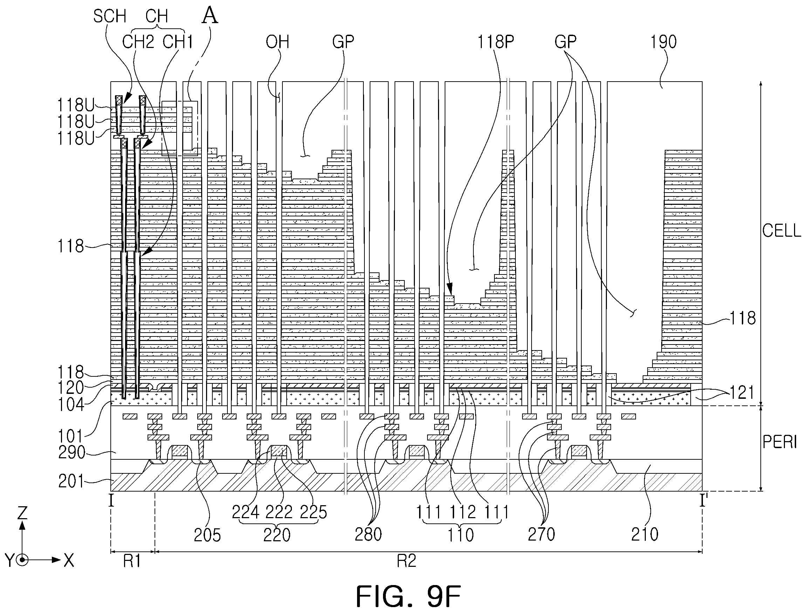

Referring to FIGS. 9F and 10A, through-holes OH penetrating through the stack structure of the sacrificial insulating layers 118 and upper sacrificial insulating layers 118U may be formed.

Through-holes OH may be formed in regions corresponding to the contact plugs 170 in FIG. 2A. The through-holes OH may be formed to penetrate through the cell region insulating layer 190, the upper sacrificial insulating layers 118U, the sacrificial insulating layers 118, and the interlayer insulating layers 120, and to penetrate through the substrate insulating layer 121 from a lower portion. The circuit interconnection lines 280 may be exposed through bottom surfaces of through-holes OH.

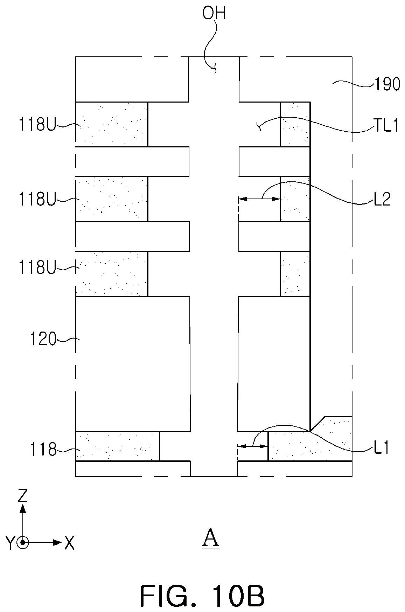

Referring to FIG. 10B, first tunnel portions TL1 may be formed by partially removing the sacrificial insulating layers 118 and the upper sacrificial insulating layers 118U exposed through the through-holes OH.

In this process, a large portion of the upper sacrificial insulating layers 118U and the sacrificial insulating layers 118 in the preliminary contact regions 118P, having a relatively thick thickness, may be removed in a horizontal direction. Accordingly, in the upper sacrificial insulating layers 118U and the preliminary contact regions 118P, the first tunnel portions TL1 may be formed with a second length L2 longer than the first length L1 of the lower region, which may be because an inflow of the etchant may be performed efficiently in a region having a relatively thick thickness. In an implementation, the upper sacrificial insulating layers 118U and the preliminary contact regions 118P may include a region in which an etching rate may be relatively faster than those of other regions of the sacrificial insulating layers 118, and accordingly, the first tunnel portions TL1 may be relatively elongated.

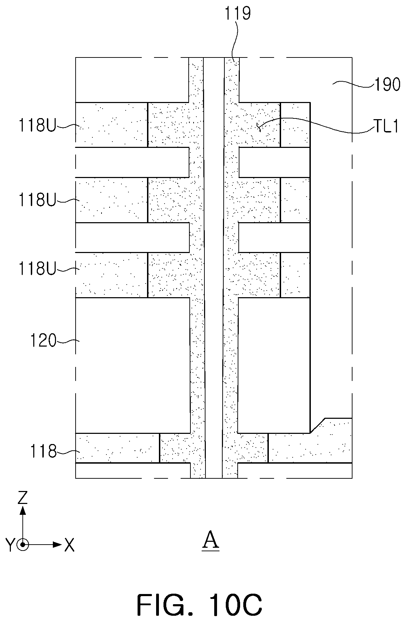

Referring to FIG. 10C, a tunnel sacrificial insulating layer 119 filling the first tunnel portions TL1 may be formed.

The tunnel sacrificial insulating layer 119 may fill the first tunnel portions TL1 and may also be partially formed on the sidewall of the through-holes OH. The tunnel sacrificial insulating layer 119 may include a material having an etch rate different from those of the upper sacrificial insulating layers 118U and the sacrificial insulating layers 118, and may include, e.g., a material having a relatively slow etch rate under a specific etching condition. In an implementation, the tunnel sacrificial insulating layer 119 may include silicon nitride or silicon oxynitride of which compositions may be different from those of the upper sacrificial insulating layers 118U and the sacrificial insulating layers 118.

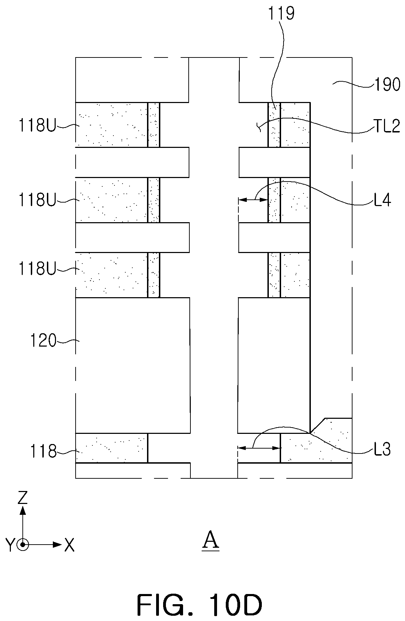

Referring to FIG. 10D, second tunnel portions TL2 may be formed by partially removing the tunnel sacrificial insulating layer 119 and the sacrificial insulating layers 118.

The etching rate of the tunnel sacrificial insulating layer 119 may be relatively slow, and the tunnel sacrificial insulating layer 119 may remain on the side surfaces of the upper sacrificial insulating layers 118U in a region adjacent to the relatively elongated upper sacrificial insulating layers 118U. The tunnel sacrificial insulating layer 119 may be entirely removed in a region adjacent to the relatively short sacrificial insulating layers 118, and the sacrificial insulating layers 118 thereby may also be partially removed. Accordingly, the length of the second tunnel portions TL2 may be reversed from that of the first tunnel portions TL1, and may have a fourth length L4 shorter than the third length L3 of the lower region.

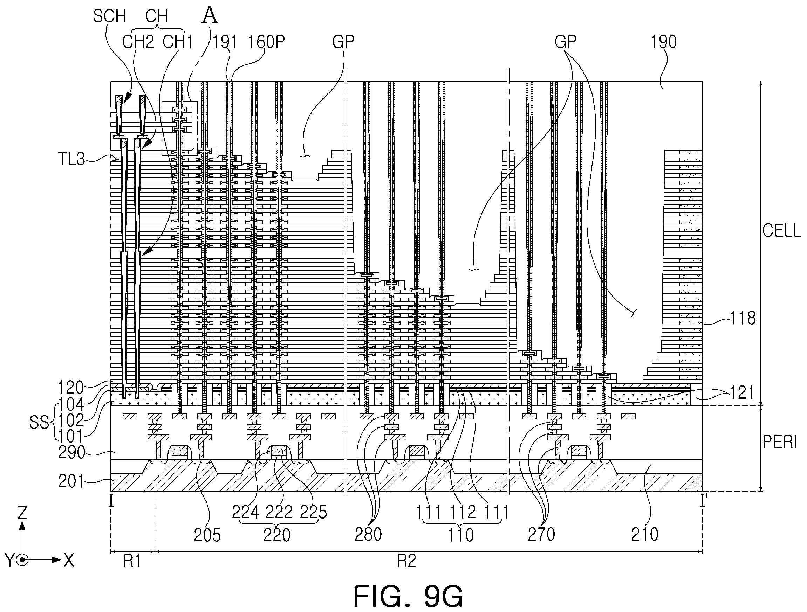

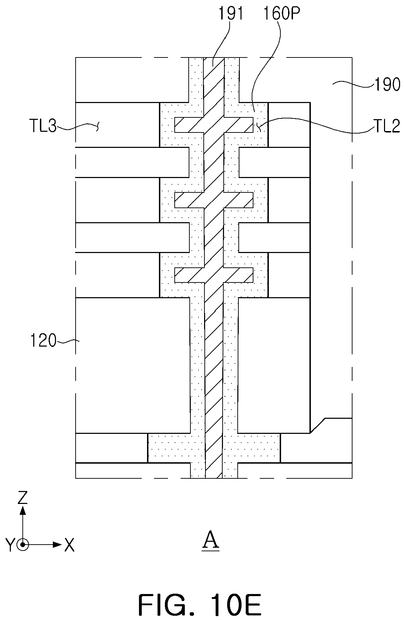

Referring to FIGS. 9G and 10E, the preliminary contact insulating layers 160P and the vertical sacrificial layers 191 may be formed in through-holes OH, and the sacrificial insulating layers 118, the upper sacrificial insulating layers 118U, and the tunnel sacrificial insulating layers 119 may be removed.

The preliminary contact insulating layers 160P may be formed by depositing an insulating material in the through-holes OH and the second tunnel portions TL2. The preliminary contact insulating layers 160P may fill the second tunnel portions TL2 and may be formed on the sidewalls of the through-holes OH. In an implementation, in a region adjacent to the upper sacrificial insulating layers 118U, the preliminary contact insulating layers 160P may not completely fill the second tunnel portions TL2.

Vertical sacrificial layers 191 may be formed on the preliminary contact insulating layers 160P, may fill through-holes OH, and may fill the second tunnel portions TL2 in a region adjacent to the upper sacrificial insulating layers 118U. The vertical sacrificial layers 191 may include a material different from that of the preliminary contact insulating layers 160P, and may include, e.g., polycrystalline silicon.

Thereafter, openings penetrating through sacrificial insulating layers 118, upper sacrificial insulating layers 118U, and interlayer insulating layers 120 and extending to the plate layer 101 may be formed in positions of first isolation regions MS (see FIG. 1). By performing an etch-back process while forming separate sacrificial spacer layers in the openings, in the first region R1, the horizontal insulating layer 110 may be selectively removed, and a portion of the exposed gate dielectric layer 145 may also be removed. A first horizontal conductive layer 102 may be formed by depositing a conductive material in the region from which the horizontal insulating layer 110 is removed, and the sacrificial spacer layers may be removed from the openings. Through this process, a first horizontal conductive layer 102 may be formed in the first region R1.

Thereafter, the sacrificial insulating layers 118 and the upper sacrificial insulating layers 118U may be selectively removed with respect to the interlayer insulating layers 120, the second horizontal conductive layer 104, and the preliminary contact insulating layers 160P using, e.g., wet etching.

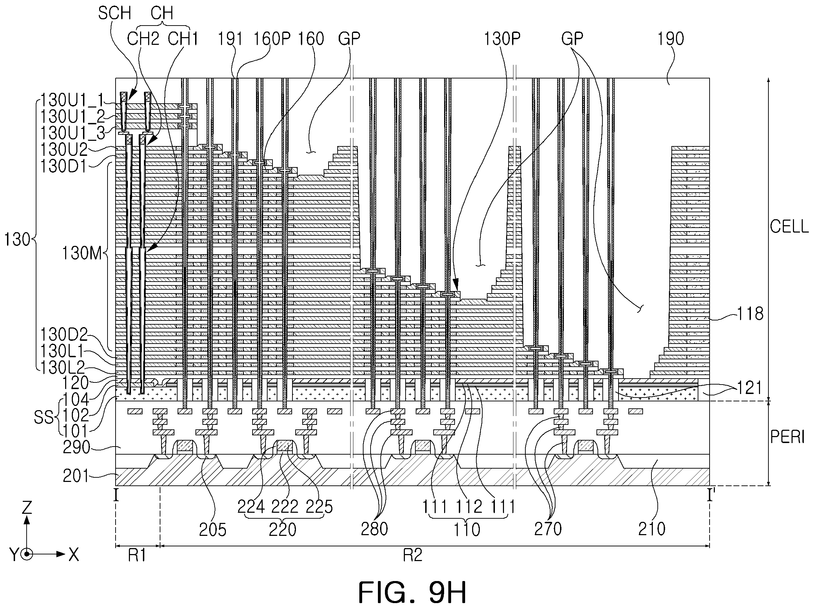

Referring to FIG. 9H, gate electrodes 130 may be formed.

The gate electrodes 130 may be formed by depositing a conductive material in regions from which the sacrificial insulating layers 118 and the upper sacrificial insulating layers 118U are removed. The conductive material may include a metal, polycrystalline silicon, or metal silicide material. In an implementation, a portion of the gate dielectric layer 145 may be formed before forming the gate electrodes 130. After forming the gate electrodes 130, the gate isolation insulating layers 105 (see FIG. 2B) may be formed in the openings formed in regions of the first isolation regions MS.

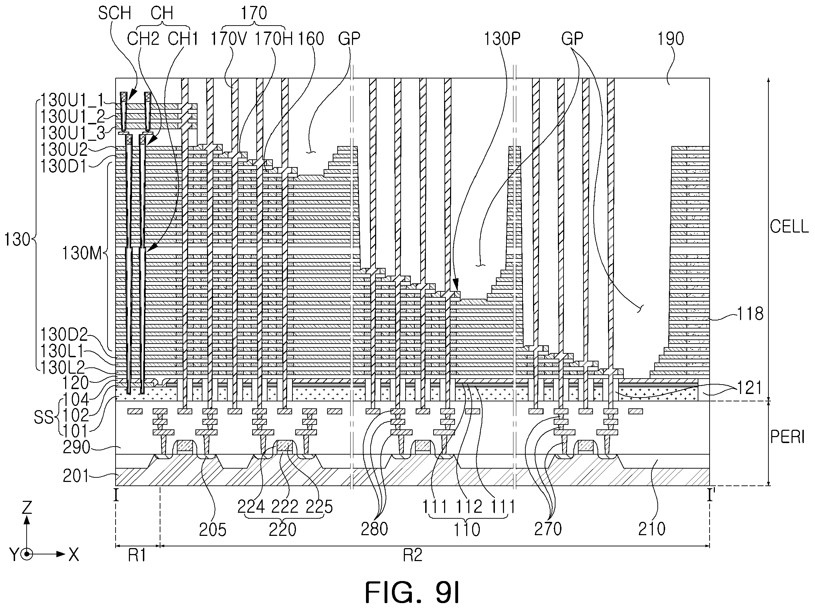

Referring to FIG. 9I, the vertical sacrificial layers 191 in the through-holes OH may be removed, and the contact plugs 170 may be formed.

The vertical sacrificial layers 191 may be selectively removed with respect to the interlayer insulating layers 120 and the gate electrodes 130. After the vertical sacrificial layers 191 are removed, a portion of the exposed preliminary contact insulating layers 160P may also be removed. In this case, the entirety of the preliminary contact insulating layers 160P may be removed from the contact regions 130P, and the preliminary contact insulating layers 160P may remain therebelow and may form the contact insulating layers 160. In the contact regions 130P, when the gate dielectric layer 145 is exposed after the preliminary contact insulating layers 160P are removed, the gate dielectric layer 145 may also be removed such that the side surface of the gate electrodes 130 may be exposed.

The contact plugs 170 may be formed by depositing a conductive material in through-holes OH. The contact plugs 170 may be formed to have horizontal extension portions 170H (see FIGS. 3A and 3B) extending horizontally from the contact regions 130P, thereby being physically and electrically connected to the gate electrodes 130.

Thereafter, referring to FIGS. 2A and 2B together, the semiconductor device 100 may be manufactured by forming studs 180 connected to upper ends of the contact plugs 170 and upper ends of the first channel structures CH.

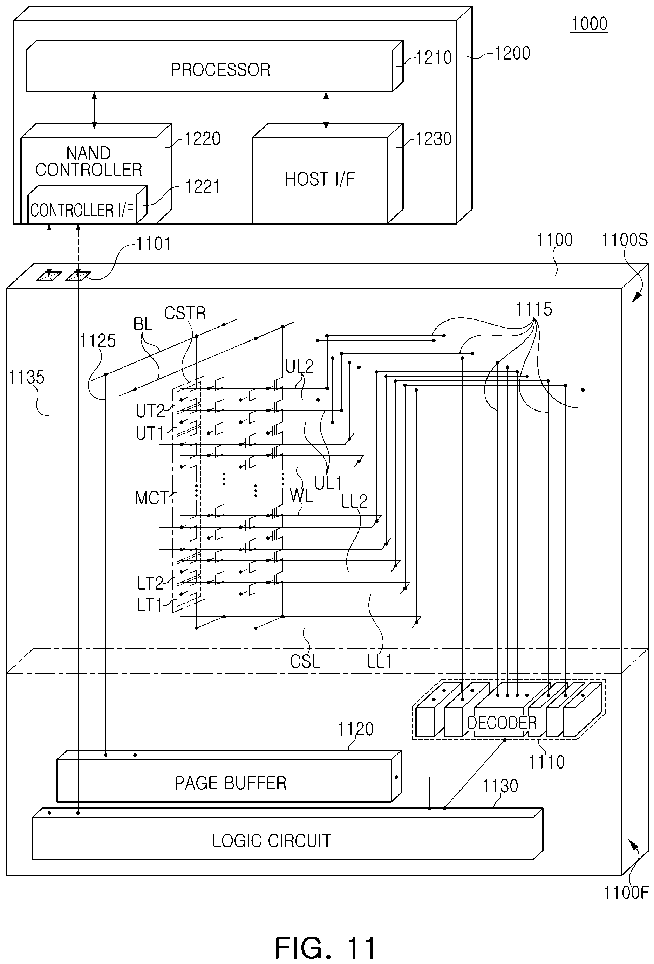

FIG. 11 is a view illustrating a data storage system including a semiconductor device according to an example embodiment

Referring to FIG. 11, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. In an implementation, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, e.g., the NAND flash memory device described in the aforementioned example embodiment with reference to FIGS. 1 to 8. The semiconductor device 1100 may include a first structure 1100F and a second structure 1 100S on the first structure 1100F. In an implementation s, the first structure 1100F may be on the side of the second structure 1100S. The first structure 1100F may be implemented as a peripheral circuit structure including a decoder circuit 1110, a page buffer 1120, and a logic circuit 1130. The logic circuit may be an example of a circuit device 220. The second structure 1100S may be implemented as a memory cell structure including a bit line BL, a common source line CSL, word lines WL, first and second gate upper lines UL1 and UL2, first and second gate lower lines LL1 and LL2 and memory cell strings CSTR disposed between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT between the lower transistors LT1 and LT2 and the upper transistors UT1 and UT2. The number of lower transistors LT1 and LT2 and the number of upper transistors UT1 and UT2 may be varied in the example embodiments.

In an implementation, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

In an implementation, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection interconnections 1115 extending from the first structure 1100F to the second structure 1100S. The bit lines BL may be electrically connected to the page buffer 1120 through second connection interconnections 1125 extending from the first structure 110F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pads 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In the example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

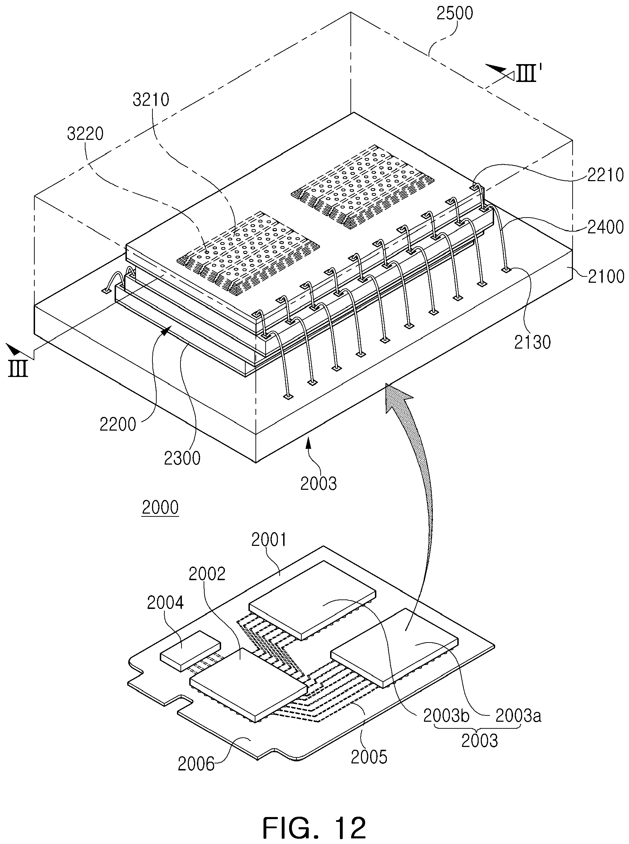

FIG. 12 is a perspective view illustrating a data storage system including a semiconductor device according to an example embodiment.

Referring to FIG. 12 a data storage system 2000 in an example embodiment may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to an external host. The number and arrangement of the plurality of pins in the connector 2006 may vary depending on a communication interface between the data storage system 2000 and the external host. In an implementation, the data storage system 2000 may communicate with an external host according to universal serial bus (USB), peripheral component interconnect express (PCI-Express), serial advanced technology attachment (SATA), or M-Phy for universal flash storage (UFS). In an implementation, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 11. Each of the semiconductor chips 2200 may include gate stack structures 3210 and channel structures 3220. Each of the semiconductor chips 2200 may include the semiconductor device described in the aforementioned example embodiment with reference to FIGS. 1 to 8.

In an implementation, the connection structure 2400 may be a bonding wire electrically connecting the input/output pad 2210 to the package upper pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In an implementation, in each of the first and second semiconductor packages 2003a and 2003b, the semiconductor chips 2200 may be electrically connected to each other by a connection structure including a through-electrode (TSV) instead of the connection structure 2400 of a bonding wire method.

In an implementation, the controller 2002 and the semiconductor chips 2200 may be included in a single package. In an implementation, the controller 2002 and the semiconductor chips 2200 may be mounted on an interposer substrate different from the main board 2001, and the controller 2002 and the semiconductor chips 2200 may be connected to each other by interconnection formed on the interposer substrate.

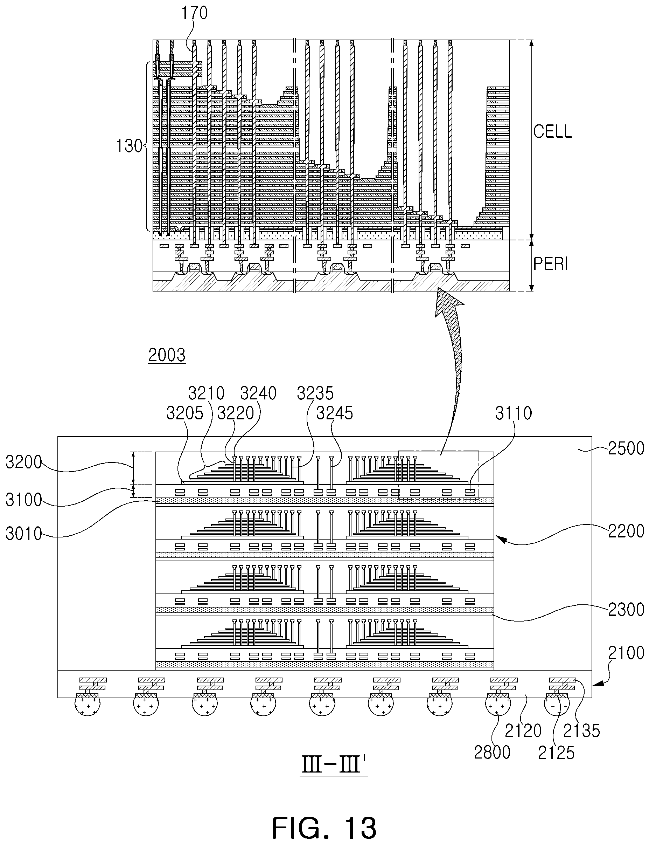

FIG. 13 is a cross-sectional view illustrating a semiconductor package according to an example embodiment, illustrating an example embodiment of the semiconductor package 2003 in FIG. 12 taken along line III-III'.

Referring to FIG. 13, in the semiconductor package 2003, the package substrate 2100 may be implemented as a printed circuit substrate. The package substrate 2100 may include includes a package substrate body portion 2120, package upper pads 2130 on an upper surface of the package substrate body portion 2120 (see FIG. 12), lower pads 2125 on the lower surface of the package substrate body portion 2120 or exposed through the lower surface, and internal interconnections 2135 electrically connecting the package upper pads 2130 to the lower pads 2125 in the package substrate body portion 2120. The lower pads 2125 may be connected to the interconnection patterns 2005 of the main board 2001 of the data storage system 2000 through the conductive connection portions 2800 as illustrated in FIG. 12.

Each of the semiconductor chips 2200 may include a semiconductor substrate 3010 and a first structure 3100 and a second structure 3200 stacked in order on the semiconductor substrate 3010. The first structure 3100 may include a peripheral circuit region including peripheral interconnections 3110. The second structure 3200 may include a common source line 3205, a gate stack structure 3210 on the common source line 3205, channel structures 3220 penetrating through the gate stack structure 3210, bit lines 3240 electrically connected to the channel structures 3220, and contact plugs 3235 electrically connected to the word lines WL (see FIG. 11) of the gate stack structure 3210. As described above with reference to FIGS. 1 to 8, a plurality of gate electrodes 130 in each of the semiconductor chips 2200 may be connected to a contact plug 170 in common.

Each of the semiconductor chips 2200 may include a through interconnection 3245 electrically connected to the peripheral interconnections 3110 of the first structure 3100 and extending into the second structure 3200. The through interconnection 3245 may be disposed on an external side of the gate stack structure 3210 and may further be disposed to penetrate through the gate stack structure 3210. Each of the semiconductor chips 2200 may further include an input/output pad 2210 (see FIG. 12) electrically connected to the peripheral interconnections 3110 of the first structure 3100.

According to the aforementioned example embodiments, by allowing a plurality of gate electrodes commonly connected to a contact plug penetrating through the gate electrodes, a semiconductor device having improved mass productivity and a data storage system including the same may be provided.

One or more embodiments may provide a semiconductor device having improved mass productivity.

One or more embodiments may provide a data storage system including a semiconductor device having improved mass productivity.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device, comprising:
a first semiconductor structure (PERI; S1) including a substrate (201), circuit devices (220) on the substrate (201), and circuit interconnection lines (280) on the circuit devices (220); and
a second semiconductor structure (CELL; S2) on the first semiconductor structure (PERI; S1) and having a first region (R1) and a second region (R2),
wherein the second semiconductor structure (CELL; S2) includes:
a plate layer (101);
gate electrodes (130) including at least one lower select gate electrode (130L2), memory gate electrodes (130M), and upper select gate electrode (130U1_1, 130U1_2, 130U1_3) stacked in order and spaced apart from each other in a vertical direction (Z) perpendicular to an upper surface of the plate layer (101) on the plate layer (101);
first channel structures (CH; CH1) penetrating through the at least one lower select gate electrode (130L2) and the memory gate electrodes (130M) and extending in the vertical direction (Z), in the first region (R1);
second channel structures (SCH; CH2) penetrating through the at least one upper select gate electrode (130U1_1, 130U1_2, 130U1_3), extending in the vertical direction (Z), and connected to the first channel structures (CH; CH1), respectively, in the first region (R1); and
contact plugs (170) penetrating through the gate electrodes (130), extending in the vertical direction (Z), and electrically connecting the gate electrodes (130) to a portion of the circuit interconnection lines (280), in the second region (R2),
wherein the gate electrodes (130) include first gate electrodes (130U2, 130U1, 130M, 130D2, 130L1, 130L2) having a first thickness (T1) in the vertical direction (Z) in the first region (R1) and second gate electrodes (130U1_1, 130U1_2, 130U1_3) having a second thickness (T3) in the vertical direction (Z) greater than the first thickness (T1) in the first region (R1), and
wherein the second gate electrodes (130U1_1, 130U1_2, 130U1_3) are commonly connected to one of the contact plugs (170).

2. The semiconductor device as claimed in claim 1, wherein the second gate electrodes (130U1_1, 130U1_2, 130U1_3) include the upper select gate electrodes (130U1_1, 130U1_2, 130U1_3).

3. The semiconductor device as claimed in claim 1 or 2, wherein:
the first gate electrodes (130U2, 130U1, 130M, 130D2, 130L1, 130L2) have a shape in which a thickness (T2) thereof is different at end regions (130P) thereof along a horizontal direction perpendicular to the vertical direction (Z), and
the second gate electrodes (130U1_1, 130U1_2, 130U1_3) have a constant thickness (T3).

4. The semiconductor device as claimed in any one of claims 1 to 3,
wherein the first gate electrodes (130U2, 130U1, 130M, 130D2, 130L1, 130L2) have a third thickness (T2) at end regions (130P) along a horizontal direction perpendicular to the vertical direction (Z).

5. The semiconductor device as claimed in any one of claims 1 to 4,
wherein the first gate electrodes (130U2, 130U1, 130M, 130D2, 130L1, 130L2) are connected to the contact plugs (170) in the end regions (130P).

6. The semiconductor device as claimed in any one of claims 1 to 5,
wherein the second thickness (T3) is in a range of about 1.05 times to about 1.50 times the first thickness (T1).

7. The semiconductor device as claimed in any one of claims 1 to 6,
wherein the second gate electrodes (130U1_1, 130U1_2, 130U1_3) extend to a same length in a horizontal direction.

8. The semiconductor device as claimed in any one of claims 1 to 7,
wherein the first gate electrodes (130U2, 130U1, 130M, 130D2, 130L1, 130L2) and the second gate electrodes (130U1_1, 130U1_2, 130U1_3) include a same material.

9. The semiconductor device as claimed in any one of claims 1 to 8,
wherein the first channel structures (CH) and the second channel structures (SCH) are laterally misaligned from each other in a horizontal direction.

10. The semiconductor device as claimed in any one of claims 1 to 9,
wherein each of the contact plugs (170) includes a vertical extension portion (170V) extending in the vertical direction (Z) and at least one horizontal extension portion (170H) extending horizontally from the vertical extension portion (170V) and in contact with one of the gate electrodes (130).

11. The semiconductor device as claimed in any one of claims 1 to 10, wherein:
the contact plug (170) connected to the second gate electrodes (130U1_1, 130U1_2, 130U1_3) includes a plurality of horizontal extension portions (170H), and
lengths of the plurality of horizontal extension portions (170H) in a horizontal direction are equal to each other.

12. The semiconductor device as claimed in any one of claims 1 to 11, wherein:
in the second region (R2), the gate electrodes (130) form a downward first step structure of which a level decreases in the vertical direction (Z) and an upward second step structure of which a level increases in the vertical direction (Z), and
the contact plugs (170) penetrate through the first step structure.

13. A data storage system, comprising:
the semiconductor device (100; 100a; 100c; 100e; 1100) of any one of the preceding claims, the semiconductor device (100; 100a; 100c; 100e; 1100) further including an input/output pad (1101) electrically connected to the circuit devices (220; 1130); and
a controller (1200) electrically connected to the semiconductor device (100; 100a; 100e; 1100) through the input/output pad (1101) and configured to control the semiconductor device (100; 100a; 100c; 100e; 1100).

14. The data storage system as claimed in claim 13, wherein the second gate electrodes (130U1_1, 130U1_2, 130U1_3) surround a side surface of the contact plug (170) connected to the second gate electrodes (130U1_1, 130U1_2, 130U1_3).
